# EUROPEAN PATENT SPECIFICATION

(11) **EP 4 425 368 B1**
(45) Date of publication and mention of the grant of the patent: **06.05.2026**
(21) Application number: 23892753.7
(22) Date of filing: 14.09.2023
(51) Int. Cl.: G06F 30/367, G01R 31/30, G01R 31/3173

(54) **CHIP INTERNAL VOLTAGE PREDICTION MODEL GENERATION METHOD, CHIP INTERNAL VOLTAGE PREDICTION METHOD, AND RELATED APPARATUSES**
VERFAHREN ZUR ERZEUGUNG EINES MODELLS ZUR VORHERSAGE DER INTERNEN SPANNUNG EINES CHIPS, VERFAHREN ZUR VORHERSAGE DER INTERNEN SPANNUNG EINES CHIPS UND ZUGEHÖRIGE VORRICHTUNGEN
PROCÉDÉ DE GÉNÉRATION DE MODÈLE DE PRÉDICTION DE TENSION INTERNE DE PUCE, PROCÉDÉ DE PRÉDICTION DE TENSION INTERNE DE PUCE ET APPAREILS ASSOCIÉS

(30) Priority: 21.12.2022 CN 202211647622
(43) Date of publication of application: 04.09.2024
(73) Proprietor: Hygon Information Technology Co., Ltd., Tianjin 300392 (CN)
(72) Inventor: DAI, Kaiyong, Tianjin 300392 (CN); YANG, Yi, Tianjin 300392 (CN); FU, Xingfei, Tianjin 300392 (CN); PAN, Yu, Tianjin 300392 (CN)
(74) Representative: Regimbeau
(86) International application number: PCT/CN2023/118879
(87) International publication number: WO 2024/131163

(56) References cited:
- CN-A- 112 908 399
- CN-A- 116 090 388
- US-A1- 2006 229 828
- US-A1- 2017 147 058
- US-A1- 2019 286 210
- US-A1- 2021 191 723
- US-B1- 9 083 229
- US-B2- 11 520 395
- YE FANGMING ET AL: "On-chip voltage-droop prediction using support-vector machines", 2014 IEEE 32ND VLSI TEST SYMPOSIUM (VTS), IEEE, 13 April 2014 (2014-04-13), pages 1 - 6, XP032596902, DOI: 10.1109/VTS.2014.6818798
- YE FANGMING; FIROUZI FARSHAD; YANG YANG; CHAKRABARTY KRISHNENDU; TAHOORI MEHDI B.: "On-Chip Droop-Induced Circuit Delay Prediction Based on Support-Vector Machines", IEEE TRANSACTIONS ON COMPUTER-AIDED DESIGN OF INTEGRATED CIRCUITS AND SYSTEMS, IEEE, USA, vol. 35, no. 4, 1 April 2016 (2016-04-01), USA, pages 665 - 678, XP011603598, ISSN: 0278-0070, DOI: 10.1109/TCAD.2015.2474392

## Description

The present application claims the priority to the Chinese Patent Application No. 202211647622.4 filed on December 21, 2022.

### TECHNICAL FIELD

Embodiments of the present disclosure relate to a generation method for a chip internal voltage prediction model, a prediction method, and related apparatuses.

### BACKGROUND

The system-level chip, also referred to as system-on-a-chip (SOC), is an integrated circuit with a dedicated target. The power supply system of the system-level chip includes: a power supply, a power line, an internal power network, and the like. The internal device of the system-level chip is connected to the internal power network, and the internal power network is connected to the power supply through the power line. During operation of the system-level chip, the power line between the internal power network and the power supply may generate a current. Meanwhile, because of the existence of the internal resistance of the power supply and the internal resistance of the internal power network, there is a voltage drop from the power supply to the internal power network, and further because the internal device is connected to the internal power network, it can be assumed that the voltage drop is a voltage decrease from the power supply to the internal device of the chip. However, when the load of the chip is suddenly increased, the rate of change of the current with time (also referred to as DIDT) suddenly increases. In the case of a short period of time when the voltage value of the power supply remains unchanged, the voltage drop from the power supply to the internal device of the chip will become larger, and the voltage on the internal device will drop sharply, which may cause the functional failure of the entire system-level chip.

One solution to the above problem is to detect DIDT-related data in the chip in real time in order to evaluate whether the chip internal voltage is abnormal, and intervene in the operating status of the chip after determining that the chip internal voltage is abnormal. However, it is usually too late to intervene in the operating status of the chip when the chip internal voltage is determined to be abnormal. Therefore, how to timely detect the abnormal chip internal voltage caused by the DIDT has become an urgent technical problem for those skilled in the art to solve

YE FANGMING ET AL: "On-chip voltage-droop prediction using support-vector machines", 2014 IEEE 32ND VLSI TEST SYMPOSIUM describes on-chip voltage droop prediction using support-vector machines.

### SUMMARY

In view of this, the embodiments of the present disclosure provide a generation method for a chip internal voltage prediction model, a prediction method, and related apparatuses, which can predict the chip internal voltage in advance.

To achieve the above-mentioned purpose, the embodiments of the present disclosure provide the following technical solutions.

In a first aspect, the embodiments of the present disclosure provide a generation method for a chip internal voltage prediction model, which includes:
obtaining a load data set and a relevant index data set of a chip respectively, where the load data set includes load data of the chip at each sampling cycle and a sampling cycle ordinal number corresponding to the load data, and the relevant index data set includes characterization data characterizing a chip internal voltage at the each sampling cycle and a sampling cycle ordinal number corresponding to the characterization data;
calibrating the relevant index data set according to a calibration cycle number and obtaining a calibrated relevant index data set; and
training the chip internal voltage prediction model based on the load data set and the calibrated relevant index data set, and obtaining the chip internal voltage prediction model with completed training.

In a second aspect, the embodiments of the present disclosure further provide a generation apparatus for a chip internal voltage prediction model, which includes:
an obtaining module, configured to obtain a load data set and a relevant index data set of a chip respectively, where the load data set includes load data of the chip at each sampling cycle and a sampling cycle ordinal number corresponding to the load data, and the relevant index data set includes characterization data characterizing a chip internal voltage at the each sampling cycle and a sampling cycle ordinal number corresponding to the characterization data;
a calibration module, configured to calibrate the relevant index data set according to a calibration cycle number and obtain a calibrated relevant index data set; and
a training module, configured to train the chip internal voltage prediction model based on the load data set and the calibrated relevant index data set and obtain the chip internal voltage prediction model with completed training.

In a third aspect, the embodiments of the present disclosure further provide a prediction method for a chip internal voltage, which includes:
obtaining real-time load data of a chip; and
obtaining prediction data of the chip internal voltage using a chip internal voltage prediction model obtained by the generation method for the chip internal voltage prediction model as described above.

In a fourth aspect, the embodiments of the present disclosure further provide a prediction apparatus for a chip internal voltage, which includes:
a real-time obtaining module, configured to obtain real-time load data of a chip; and
a prediction module, configured to obtain prediction data of the chip internal voltage using a chip internal voltage prediction model obtained by the generation method for the chip internal voltage prediction model as described above.

In a fifth aspect, the embodiments of the present disclosure further provide a storage medium; and the storage medium stores a program adapted for generation of a chip internal voltage prediction model so as to implement the generation method for the chip internal voltage prediction model as described above, or the storage medium stores a program adapted for prediction of a chip internal voltage so as to implement the prediction method for the chip internal voltage as described above.

In a sixth aspect, the embodiments of the present disclosure further provide an electronic device, the electronic device includes at least one memory and at least one processor, the memory stores a program, and the processor invokes the program to perform the generation method for the chip internal voltage prediction model as described above, or to perform the prediction method for the chip internal voltage as described above.

In a seventh aspect, the embodiments of the present disclosure further provide a chip, and the chip includes: an instruction counting unit, configured to obtain a number of each type of instructions in an instruction life cycle of the chip; a cache access counting unit, configured to obtain a number of reads and writes in progress in a cache of the chip; and a prediction unit, configured to obtain, using a chip internal voltage prediction model obtained by the generation method for the chip internal voltage prediction model as described above, prediction data of a chip internal voltage according to the number of each type of instructions obtained by the instruction counting unit and the number of reads and writes obtained by the cache access counting unit.

It can be seen that the generation method for the chip internal voltage prediction model, the prediction method, and the related apparatuses provided in the embodiments of the present disclosure can predict the situation of the chip internal voltage in advance, so that the abnormality of the chip internal voltage can be detected in advance based on the predicted chip internal voltage, and corresponding intervention can be made timely in the operating status of the chip.

### BRIEF DESCRIPTION OF THE DRAWINGS

In order to clearly illustrate the technical solutions of the embodiments of the present disclosure, the drawings of the embodiments will be briefly described in the following. It is obvious that the described drawings are only related to some embodiments of the present disclosure, and for those skilled in the art, other drawings can be obtained based on these provided drawings without any inventive work.
FIG. 1 is a schematic diagram of a power supply structure of a system-level chip;
FIG. 2 is a flowchart of a generation method for a chip internal voltage prediction model provided by an embodiment of the present disclosure;
FIG. 3 is a schematic diagram of an instruction life cycle related to an embodiment of the present disclosure;
FIG. 4 is a schematic diagram of a system-level chip structure configured with a power monitor related to an embodiment of the present disclosure;
FIG. 5 is a flowchart of a calculation method for a calibration cycle number provided by an embodiment of the present disclosure;
FIG. 6 is a flowchart of a prediction method for a chip internal voltage provided by an embodiment of the present disclosure;
FIG. 7 is a block diagram of a generation apparatus for a chip internal voltage prediction model provided by an embodiment of the present disclosure;
FIG. 8 is a block diagram of a calibration module of a generation apparatus for a chip internal voltage prediction model provided by an embodiment of the present disclosure; and
FIG. 9 is a block diagram of a prediction apparatus for a chip internal voltage provided by an embodiment of the present disclosure.

### DETAILED DESCRIPTION

The technical solutions in the embodiments of the present disclosure will be described in a clearly and fully understandable way in conjunction with the drawings in the embodiments of the present disclosure. Obviously, the described embodiments are only a part but not all of the embodiments of the present disclosure. Based on the embodiments of the present disclosure, all other embodiments obtained by those skilled in the art without any inventive work should be within the protection scope of the present disclosure.

As described in the background, by detecting the DIDT-related data in the integrated circuit in real time, it is determined whether the chip internal voltage is abnormal, so that the intervention can be made in the operating status of the integrated circuit. The detection method for the chip internal voltage is described below.

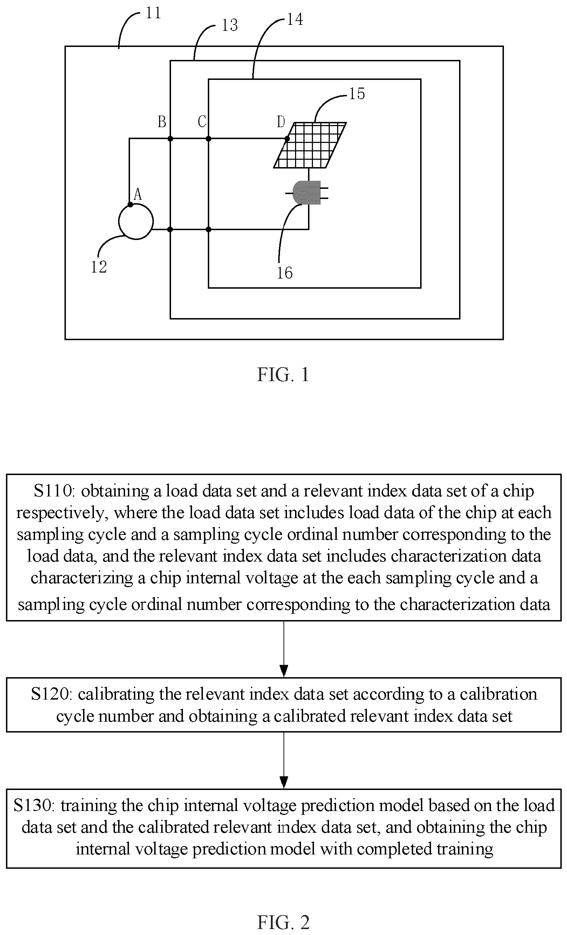

Referring to FIG. 1, FIG. 1 illustrates a schematic diagram of a power supply structure of a system-level chip. The system-level chip in the example may be an integrated circuit with a dedicated target, and the system-level chip contains a complete system with all the contents of the embedded software.

As illustrated in FIG. 1, the power supply structure of the integrated circuit forming the system-level chip mainly includes a power supply 12, a power line, an internal power network 15, and an internal device 16 of the integrated circuit. The power supply 12 may be provided on the board 11 on which the integrated circuit is located. The power output by the power supply 12 enters the integrated circuit substrate 13 through the power line AB, and then enters the inside of the integrated circuit 14 through the power line BC between the integrated circuit substrate 13 and the integrated circuit pin, so as to be connected, inside the integrated circuit 14, to the internal power network 15 through the power line CD. The power voltage of the power supply 12 may be controlled by the power supply control module. The internal device 16 of the integrated circuit refers to the internal device of the integrated circuit in a power-consuming operating status, and the internal device 16 of the integrated circuit is directly connected to different locations of the internal power network 15. The power line can be understood as a general term for the components such as wires, leads, and pins that achieve an electrical connection from the power supply 12 to the internal power network 15.

During the operation of the integrated circuit, the power line between the internal power network 15 and the power supply 12 generates a current. Meanwhile, because of the existence of the internal resistance of the power supply and the internal resistance of the internal power network, there is a voltage drop from the power supply 12 to the internal power network 15, and further because the internal device 16 of the integrated circuit is connected to the internal power network 15, it can be assumed that the voltage drop is a voltage decrease from the power supply 12 to the internal device 16 of the integrated circuit.

When the load of the integrated circuit is small or there is no load, the power supply 12 can provide a stable voltage output, and the voltage output can be fully applied to the internal device 16 of the integrated circuit. However, when the load of the integrated circuit 14 is suddenly increased, that is, when the number of internal devices 16 of the integrated circuit that are working at the same time increases, the rate of change of the current with time (also referred to as DIDT) suddenly increases. In the case of a short period of time when the voltage value of the power supply remains unchanged, the voltage drop from the power supply 12 to the internal device 16 of the integrated circuit will become larger, and the voltage on the internal device 16 of the integrated circuit will drop sharply, thereby causing an increase in the delay of the internal device 16 of the integrated circuit, which is unable to satisfy the establishment time of the register on the critical path, thus causing the functional failure of the entire integrated circuit.

One solution is to detect DIDT-related data in the integrated circuit in real time in order to estimate the internal voltage of the integrated circuit, and to make corresponding intervention in the operating status of the integrated circuit when it is estimated that the internal voltage of the integrated circuit is abnormal.

It can be seen that the above solution estimates the real-time situation of the chip internal voltage when the DIDT occurs, and when it is determined that the chip internal voltage is abnormal according to the estimated real-time situation of the chip internal voltage, it is often too late to make corresponding intervention in the operating status of the chip.

In response to the above-mentioned problem, one aspect of the embodiments of the present disclosure provides a generation method for a chip internal voltage prediction model, and the method includes:
obtaining a load data set and a relevant index data set of a chip respectively, where the load data set includes load data of the chip at each sampling cycle and a sampling cycle ordinal number corresponding to the load data, and the relevant index data set includes characterization data characterizing a chip internal voltage at the each sampling cycle and a sampling cycle ordinal number corresponding to the characterization data;
calibrating the relevant index data set according to a calibration cycle number and obtaining a calibrated relevant index data set; and
training the chip internal voltage prediction model based on the load data set and the calibrated relevant index data set, and obtaining the chip internal voltage prediction model with completed training.

In response to the above-mentioned problem, another aspect of the embodiments of the present disclosure provides a prediction method for a chip internal voltage, and the method includes:
obtaining real-time load data of a chip; and
obtaining prediction data of the chip internal voltage using a chip internal voltage prediction model obtained by the generation method for the chip internal voltage prediction model as described above.

It can be seen that the generation method for the chip internal voltage prediction model, the prediction method, and the related apparatuses provided in the embodiments of the present disclosure can predict the situation of the chip internal voltage in advance, so that the abnormality of the chip internal voltage can be detected in advance based on the predicted chip internal voltage, and corresponding intervention can be made timely in the operating status of the chip.

For better understanding and implementation by those skilled in the art, the following is a detailed description of the ideas, principles, and advantages of the embodiments of the present disclosure by means of specific embodiments as well as in conjunction with the specific application scenarios and drawings.

The prediction method for the chip internal voltage provided by the embodiments of the present disclosure will be described in detail below.

In order to enable the chip internal voltage prediction model to achieve the expected performance index, the chip internal voltage prediction model needs to be pre-tested with a training set until it meets the demand of the expected performance index, and then the required chip internal voltage prediction model is generated. For better understanding and implementation by those skilled in the art, the generation process for the chip internal voltage prediction model is first introduced in detail below in conjunction with the specific application examples and drawings.

Referring to the flowchart of the generation method for the chip internal voltage prediction model illustrated in FIG. 2, in some embodiments of the present disclosure, the following steps may be used to generate a chip internal voltage prediction model for predicting the chip internal voltage:

Step S110: obtaining a load data set and a relevant index data set of a chip respectively, where the load data set includes load data of the chip at each sampling cycle and a sampling cycle ordinal number corresponding to the load data, and the relevant index data set includes characterization data characterizing a chip internal voltage at the each sampling cycle and a sampling cycle ordinal number corresponding to the characterization data.

In order to achieve the training of the chip internal voltage prediction model, it needs to first obtain the data for training. Specifically, in this step, the load data set and the relevant index data set need to be obtained respectively.

The load data set includes load data of the chip at each sampling cycle and a sampling cycle ordinal number corresponding to the load data. The sampling cycle may be a predetermined length of time. For example, in some examples, a clock cycle of the chip may be selected as the sampling cycle, and the load data set is the load data of the chip in each clock cycle. In some other examples, the sampling cycle may also be an integer multiple of the clock cycle. It can be understood that the sampling cycle may be set according to the actual situation.

The chip load data can reflect the load situation of the integrated circuit. As an example, the load data may be at least one of the instruction data and the cache data of the integrated circuit, and both of the above data can reflect the load situation of the integrated circuit. Correspondingly, the load data set may be an instruction data set or a cache data set, or may include both the instruction data set and the cache data set.

In some embodiments, the load data is the instruction data of the integrated circuit. The instruction data is the number of each type of instructions in an instruction life cycle of the integrated circuit in the sampling cycle. When the sampling cycle is the clock cycle of the integrated circuit, the instruction data is the number of each type of instructions in the instruction life cycle of the integrated circuit in one clock cycle, and the instruction data set is the number of each type of instructions in the instruction life cycle of the integrated circuit in each clock cycle.

The instruction life cycle begins with the fetching of the instruction and ends with the completion of the execution of the instruction. That is, if an instruction is at a certain stage between the fetching of the instruction and the execution of the instruction, the instruction can be considered to be in the instruction life cycle.

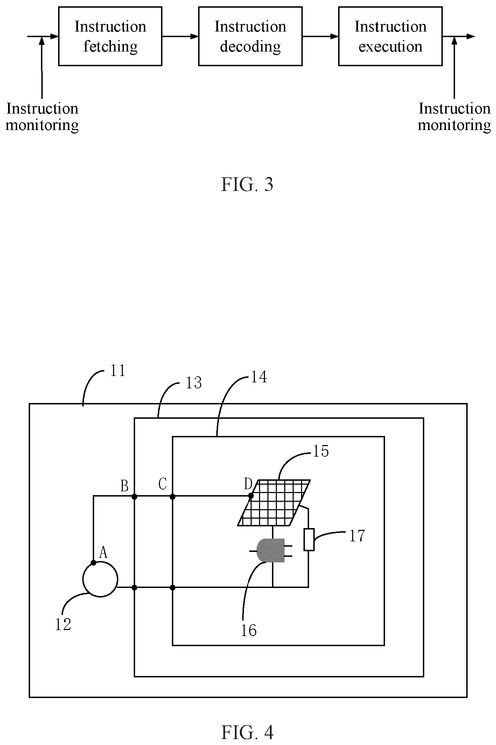

As an example, an instruction counting unit within the integrated circuit may be utilized to record the number of each type of the instructions in the instruction life cycle in each clock cycle. FIG. 3 illustrates the instruction life cycle and the monitoring of the instruction by the instruction counting unit. Specifically, the instruction counting unit monitors the situation of the instruction at the instruction fetching point and the instruction execution point respectively, dynamically counts the number of each type of the instructions in the instruction life cycle, and updates the statistical situation of the instruction once per clock cycle.

Specifically, the instruction counting unit performs the statistical method for instructions as follows:

If it is monitored that an instruction enters at the instruction fetching point, it is determined whether any instruction of the identical type to this instruction finishes being executed; if no instruction of the identical type finishes being executed, the number of the instruction type corresponding to this instruction is increased by one; and if there is an instruction of the identical type that finishes being executed, the number of the instruction type corresponding to this instruction remains unchanged.

If it is monitored that an instruction finishes being executed at the instruction execution point, it is determined whether any instruction of the identical type to this instruction enters; if there is an instruction of the identical type that enters, the number of the instruction type corresponding to this instruction remains unchanged; and if no instruction of the identical type enters, the number of the instruction type corresponding to this instruction is decreased by one.

In some embodiments, the load data is the cache data of the integrated circuit. The cache data is the number of reads and writes to the cache of the integrated circuit in the sampling cycle. When the sampling cycle is the clock cycle of the integrated circuit, the cache data is the number of reads and writes to the cache of the integrated circuit in one clock cycle, and the cache data set is the number of reads and writes to the cache of the integrated circuit in each clock cycle.

As an example, a cache access counting unit in the integrated circuit may be utilized to record the number of reads and writes to the cache in each clock cycle. Specifically, the cache access counting unit may dynamically count the number of read and write commands that have been sent but not yet completed when the cache misses, and the statistical situation of the cache access is updated once per clock cycle.

The relevant index data set includes characterization data characterizing the chip internal voltage in each sampling cycle and a sampling cycle ordinal number corresponding to the characterization data. The chip internal voltage may be a voltage on a chip internal power network, and the characterization data may be power supply monitoring data (e.g., PSM value) and/or power consumption data of the integrated circuit. The power supply monitoring data and power consumption data of the integrated circuit can be used to indirectly estimate the situation of the chip internal voltage. It can be understood that the characterization data may also be data reflecting the chip internal voltage, and such data indirectly characterizes the chip internal voltage using the power consumption or reading of the chip internal power supply monitoring module as an intermediate quantity.

The characterization data corresponds to the load data, the characterization data has a temporal correspondence with the load data, and the characterization data and the corresponding load data are both collected from the same sampling cycle. As an example, if load data is collected from the m-th clock cycle, the characterization data corresponding to the load data is also collected from the m-th clock cycle.

As an example, a real-time voltage detection unit in the integrated circuit may be used to record the characterization data capable of characterizing the chip internal voltage in each clock cycle. Specifically, with reference to FIG. 4, the real-time voltage detection unit may be a power supply monitor (PSM) 17. The PSM 17 is connected to the internal power network 15 of the integrated circuit, and the PSM 17 includes a counter and a ring oscillator composed of an inverter. The ring oscillator can generate different frequency clocks according to different PVTs (e.g., process, voltage, temperature) of the current integrated circuit, the counter can count the frequency clocks generated by the ring oscillator, and the counting value per unit time (e.g., PSM value) can reflect the situation of the voltage of the integrated circuit at the temperature and process. That is, the voltage value of the load can be understood through the PSM value, and when the unit time is small enough, the magnitude of the PSM value can reflect the instantaneous value of the voltage.

Step S120: calibrating the relevant index data set according to a calibration cycle number and obtaining a calibrated relevant index data set.

After obtaining the relevant index data set, the relevant index data set needs to be calibrated, and the calibrated relevant index data set is used as a training set for the chip internal voltage prediction model.

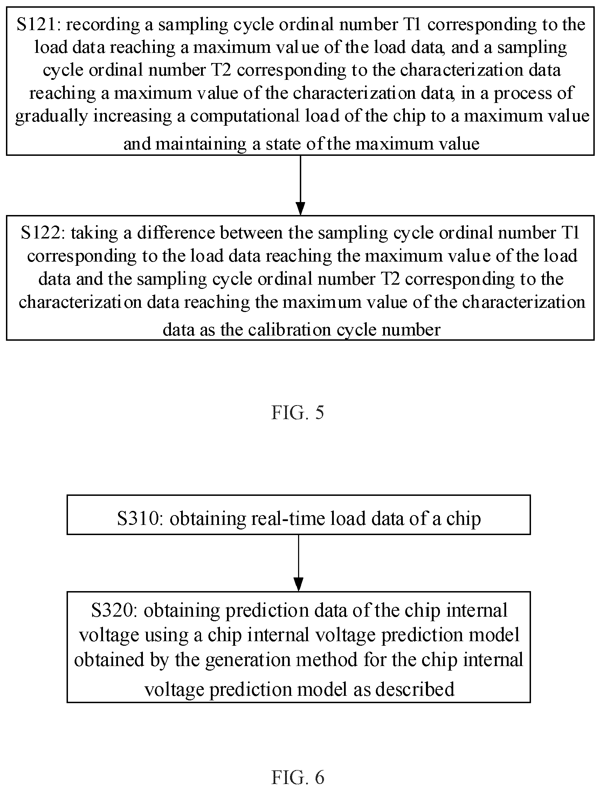

Referring to FIG. 5, during the calibration process, the calculation method for the calibration cycle number includes:

Step S121: recording a sampling cycle ordinal number T1 corresponding to the load data reaching a maximum value of the load data, and a sampling cycle ordinal number T2 corresponding to the characterization data reaching a maximum value of the characterization data, in a process of gradually increasing a computational load of the chip to a maximum value and maintaining a state of the maximum value.

Step S122: taking a difference between the sampling cycle ordinal number T1 corresponding to the load data reaching the maximum value of the load data and the sampling cycle ordinal number T2 corresponding to the characterization data reaching the maximum value of the characterization data as the calibration cycle number.

In a specific example, the computational load of the integrated circuit is gradually increased to a maximum value and continues to be maintained at the maximum value level after reaching the maximum value, and at the same time the load data and the characterization data of the integrated circuit also gradually change with the increase of the computational load until a maximum value occurs. The sampling cycle ordinal number corresponding to the occurrence of the maximum value of the load data is T1, and the sampling cycle ordinal number corresponding to the occurrence of the maximum value of the characterization data is T2. The difference between T1 and T2 can be used as the calibration cycle number.

Sequentially increasing in the computational load of the integrated circuit may be achieved by sequentially increasing the number of computing units running in the integrated circuit. Specifically, if an integrated circuit includes m computing units, the number of running computing units may be controlled to increase sequentially from 0 to m. As an example, the number of running computing units may be controlled through a pre-written program, so that the number of running computing units increases sequentially.

In some embodiments, the load data includes instruction data, and the calibration cycle number can be calculated based on the sampling cycle ordinal number corresponding to the instruction data reaching a maximum value, and the sampling cycle ordinal number corresponding to the characterization data reaching a maximum value.

In some embodiments, the load data includes cache data, and the calibration cycle number can be calculated based on the sampling cycle ordinal number corresponding to the cache data reaching a maximum value, and the sampling cycle ordinal number corresponding to the characterization data reaching a maximum value.

After calculating the calibration cycle number, the relevant index data set may be calibrated according to the calibration cycle number. Specifically, the calibration method includes: reducing the sampling cycle ordinal number corresponding to the characterization data in the relevant index data set by the calibration cycle number.

As an example, assuming that the calculated calibration cycle number is Tₐ and the sampling cycle ordinal number corresponding to certain characterization data in the relevant index data set is T, the sampling cycle ordinal number corresponding to the characterization data after calibration is T' = T - Tₐ.

Step S130: training the chip internal voltage prediction model based on the load data set and the calibrated relevant index data set, and obtaining the chip internal voltage prediction model with completed training.

After obtaining the load data set and the calibrated relevant index data set, using the chip internal voltage prediction model to be trained, a prediction chip internal voltage value is obtained based on the load data of each cycle, a loss value is obtained based on the prediction chip internal voltage value and the calibrated relevant index data, the parameter of the chip internal voltage prediction model is adjusted according to the loss value until the loss value satisfies a loss threshold, and a trained chip internal voltage prediction model and a model coefficient matrix are obtained.

After obtaining the trained chip internal voltage prediction model and the model coefficient matrix, the above chip internal voltage prediction model can be used to predict the change of the chip internal voltage in advance. In some embodiments, the trained internal voltage prediction model parameters are stored in an on-chip storage space of the chip, and the chip can read the above internal voltage prediction model parameters as needed.

As an example, the trained internal voltage prediction model parameters are stored inside the fuse of the chip. The model parameters stored in the fuse will be read when the chip is activated. The artificial intelligence engine on the chip is initialized. The detection module in the chip detects the relevant parameters characterizing the load in real time and inputs them into the artificial intelligence engine, and the artificial intelligence engine predicts the voltage of the chip in advance.

In some embodiments, an intervention module is further provided inside the chip. The artificial intelligence engine predicts the voltage of the chip in advance and transfers it to the intervention module, and the intervention module intervenes in advance according to the prediction. For example, if it is predicted that the voltage will drop, the intervention module can compensate correspondingly in advance.

It can be seen that the generation method for the chip internal voltage prediction model provided in the embodiments of the present disclosure, when training the chip internal voltage prediction model to be trained, uses the data value reflecting the chip load and the data value reflecting the chip internal voltage obtained to construct a relationship between the load data value and the chip internal voltage in the chip internal voltage prediction model, so as to prepare for the subsequent use of the trained chip internal voltage prediction model to predict the future chip internal voltage based on the load data that can be obtained at the current moment. In this way, the chip internal voltage can be predicted in advance, so that it is possible to determine in advance whether the chip internal voltage will be abnormal and intervention can be made timely in the operating status of the chip.

The prediction method for the chip internal voltage provided by the embodiments of the present disclosure is described below.

In order to achieve the prediction of the chip internal voltage, the present disclosure further provides a prediction method for a chip internal voltage. Referring to the flowchart of the prediction method for the chip internal voltage illustrated in FIG. 6, in some embodiments of the present disclosure, the following steps may be used to predict the chip internal voltage.

Step S310: obtaining real-time load data of a chip.

The real-time load data of the chip can reflect the current load situation of the chip. As an example, the load data includes at least one of the instruction data and the cache data, and both of the above data can reflect the current load situation of the integrated circuit.

The instruction data is the number of each type of instructions in an instruction life cycle of the chip in the current sampling cycle. When the sampling cycle is a clock cycle of the integrated circuit, the instruction data is the number of each type of the instructions in the instruction life cycle of the chip in the current clock cycle.

The cache data is the number of reads and writes to the cache of the chip in the current sampling cycle. When the sampling cycle is a clock cycle of the chip, the cache data is the number of reads and writes to the cache of the chip in the current clock cycle.

Step S320: obtaining prediction data of the chip internal voltage using a chip internal voltage prediction model obtained by the generation method for the chip internal voltage prediction model as described above.

After obtaining the real-time load data of the integrated circuit, the chip internal voltage is further predicted.

In specific prediction, the real-time load data is input into the above-mentioned chip internal voltage prediction model to obtain the chip internal voltage prediction data.

It can be understood that after obtaining the chip internal voltage prediction data, the chip internal voltage can be predicted in advance as described above, and it can be known in advance whether the chip internal voltage will be abnormal. If the chip internal voltage is abnormal, intervention can be timely made in the operating status of the integrated circuit so as to avoid the functional failure of the integrated circuit.

It can be seen that the prediction method for the chip internal voltage provided in the present disclosure can predict the chip internal voltage in advance, so that it can be known in advance whether the chip internal voltage will be abnormal. If the chip internal voltage is abnormal, intervention can be timely made in the operating status of the chip so as to avoid the functional failure of the chip.

The generation apparatus for the chip internal voltage prediction model and the prediction apparatus for the chip internal voltage provided by the embodiments of the present disclosure are described below. The generation apparatus for the chip internal voltage prediction model and the prediction apparatus for the chip internal voltage described below may be considered as a functional module architecture required for the electronic device to respectively implement the generation method for the chip internal voltage prediction model and the prediction method for the chip internal voltage provided in the embodiments of the present disclosure. The contents of the generation apparatus for the chip internal voltage prediction model and the prediction apparatus for the chip internal voltage described below may be cross-referenced to the contents of the generation method for the chip internal voltage prediction model and the prediction method for the chip internal voltage described above, respectively.

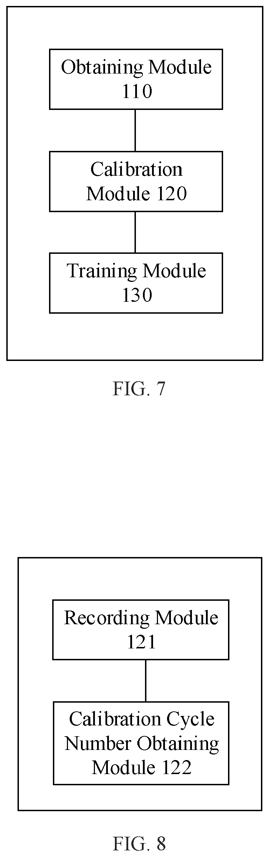

FIG. 7 is a schematic block diagram of a generation apparatus for a chip internal voltage prediction model provided in an embodiment of the present disclosure, and the generation apparatus for the chip internal voltage prediction model includes:
an obtaining module 110, configured to obtain a load data set and a relevant index data set of a chip respectively, where the load data set includes load data of the chip at each sampling cycle and a sampling cycle ordinal number corresponding to the load data, and the relevant index data set includes characterization data characterizing a chip internal voltage at the each sampling cycle and a sampling cycle ordinal number corresponding to the characterization data;
a calibration module 120, configured to calibrate the relevant index data set according to a calibration cycle number and obtain a calibrated relevant index data set; and
a training module 130, configured to train the chip internal voltage prediction model based on the load data set and the calibrated relevant index data set and obtain the chip internal voltage prediction model with completed training.

Referring to FIG. 8, in some embodiments, the calibration module 120 further includes:
a recording module 121, configured to record a sampling cycle ordinal number T1 corresponding to the load data reaching a maximum value of the load data, and a sampling cycle ordinal number T2 corresponding to the characterization data reaching a maximum value of the characterization data, in a process of gradually increasing a computational load of the chip to a maximum value and maintaining a state of the maximum value; and
a calibration cycle number obtaining module 122, configured to take a difference between the sampling cycle ordinal number T1 corresponding to the load data reaching the maximum value of the load data and the sampling cycle ordinal number T2 corresponding to the characterization data reaching the maximum value of the characterization data as the calibration cycle number.

After obtaining the trained chip internal voltage prediction model and the model coefficient matrix, the above chip internal voltage prediction model can be used to predict the change of the chip internal voltage in advance.

In some embodiments, the trained internal voltage prediction model parameters are stored in an on-chip storage space of the chip, and the chip can read the above model parameters as needed. As an example, the trained internal voltage prediction model parameters are stored inside the fuse of the chip. The model parameters stored in the fuse will be read when the chip is activated. The artificial intelligence engine on the chip is initialized, the detection module in the chip detects the relevant parameters characterizing the load in real time and inputs them into the artificial intelligence engine, and the artificial intelligence engine predicts the voltage of the chip in advance.

In some embodiments, an intervention module is further provided inside the chip. The artificial intelligence engine predicts the voltage of the chip in advance and transfers it to the intervention module, and the intervention module intervenes in advance according to the prediction. For example, if it is predicted that the voltage will drop, the intervention module can compensate correspondingly in advance.

It can be seen that the generation apparatus for the chip internal voltage prediction model provided in the embodiments of the present disclosure, when training the chip internal voltage prediction model to be trained, uses the data value reflecting the load of the integrated circuit and the data value reflecting the chip internal voltage of the integrated circuit obtained to construct a relationship between the load data value and the chip internal voltage in the chip internal voltage prediction model, so as to prepare for the subsequent use of the trained chip internal voltage prediction model to predict the future chip internal voltage based on the load data that can be obtained at the current moment. In this way, the chip internal voltage in the integrated circuit can be predicted in advance, so that it is possible to determine in advance whether the chip internal voltage will be abnormal and intervention can be made timely in the operating status of the integrated circuit.

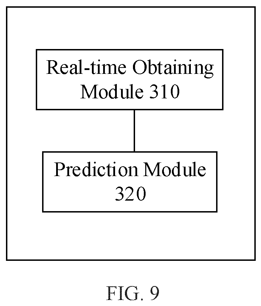

FIG. 9 is a schematic block diagram of a prediction apparatus for a chip internal voltage provided in an embodiment of the present disclosure, and the prediction apparatus for the chip internal voltage includes:
a real-time obtaining module 310, configured to obtain real-time load data of a chip; and
a prediction module 320, configured to obtain prediction data of the chip internal voltage according to the real-time load data using a chip internal voltage prediction model obtained by the generation method for the chip internal voltage prediction model as described above.

The real-time load data of the chip can reflect the current load situation of the chip. As an example, the load data may be at least one of the instruction data and the cache data, and both of the above data can reflect the current load situation of the integrated circuit.

The instruction data is the number of each type of the instructions in an instruction life cycle of the chip in the current cycle. When the cycle is a clock cycle of the integrated circuit, the instruction data is the number of each type of the instructions in the instruction life cycle of the chip in the current clock cycle.

The cache data is the number of reads and writes to the cache of the chip in the current cycle. When the cycle is a clock cycle of the chip, the cache data is the number of reads and writes to the cache of the chip in the current clock cycle.

After obtaining the real-time load data of the integrated circuit, the chip internal voltage is further predicted.

In specific prediction, the real-time load data is input into the above-mentioned chip internal voltage prediction model to obtain the chip internal voltage prediction data.

It can be understood that after obtaining the chip internal voltage prediction data, the chip internal voltage can be predicted in advance as described above, and it can be known in advance whether the chip internal voltage will be abnormal. If the chip internal voltage is abnormal, intervention can be timely made in the operating status of the integrated circuit so as to avoid the functional failure of the integrated circuit.

Further, the embodiments of the present disclosure further provide a chip, which includes:
an instruction counting unit, configured to obtain a number of each type of instructions in an instruction life cycle of the chip;
a cache access counting unit, configured to obtain the number of reads and writes in progress in a cache of the chip; and
a prediction unit, configured to obtain, using a chip internal voltage prediction model obtained by the generation method for the chip internal voltage prediction model as described above, prediction data of a chip internal voltage according to the number of each type of instructions obtained by the instruction counting unit and the number of reads and writes obtained by the cache access counting unit.

It can be seen that the generation method for the chip internal voltage prediction model, the prediction method, and the related apparatuses provided in the present disclosure can predict the chip internal voltage in advance, so that it can be known in advance whether the chip internal voltage will be abnormal. If the chip internal voltage is abnormal, intervention can be timely made in the operating status of the chip so as to avoid the functional failure of the chip.

The plurality of embodiment solutions provided by the embodiments of the present disclosure are described above. The optional methods introduced in each embodiment solution can be combined and cross-referenced with each other in case of no conflict, thereby extending a variety of possible embodiment solutions, which may be considered to be embodiment solutions disclosed by the embodiments of the present disclosure.

Although the embodiments of the present disclosure are disclosed as above, the present disclosure is not limited thereto. Any skilled person in the art can make various changes and modifications without departing from the scope of the present disclosure, and therefore the protection scope of the present disclosure should be based on the scope limited by the claims.

## Claims

1. A generation method for a chip internal voltage prediction model, comprising:
obtaining (S110) a load data set and a relevant index data set of a chip respectively, wherein the load data set comprises load data of the chip at each sampling cycle and a sampling cycle ordinal number corresponding to the load data, and the relevant index data set comprises characterization data characterizing a chip internal voltage at the each sampling cycle and a sampling cycle ordinal number corresponding to the characterization data;
calibrating (S120) the relevant index data set according to a calibration cycle number and obtaining a calibrated relevant index data set; and
training (S130) the chip internal voltage prediction model based on the load data set and the calibrated relevant index data set, and obtaining the chip internal voltage prediction model with completed training.

2. The generation method for the chip internal voltage prediction model according to claim 1, wherein the load data comprises instruction data and/or cache data, the instruction data is a number of each type of instructions in an instruction life cycle of the chip, and the cache data is a number of reads and writes in progress in a cache of the chip.

3. The generation method for the chip internal voltage prediction model according to claim 1 or 2, wherein the characterization data is power monitoring data and/or power consumption data.

4. The generation method for the chip internal voltage prediction model according to any one of claims 1-3, wherein in calibrating the relevant index data set according to the calibration cycle number and obtaining the calibrated relevant index data set, a calculation method for the calibration cycle number comprises:
recording (S121) a sampling cycle ordinal number T1 corresponding to the load data reaching a maximum value of the load data, and a sampling cycle ordinal number T2 corresponding to the characterization data reaching a maximum value of the characterization data, in a process of gradually increasing a computational load of the chip to a maximum value and maintaining a state of the maximum value; and
taking a difference (S122) between the sampling cycle ordinal number T1 corresponding to the load data reaching the maximum value of the load data and the sampling cycle ordinal number T2 corresponding to the characterization data reaching the maximum value of the characterization data as the calibration cycle number.

5. The generation method for the chip internal voltage prediction model according to any one of claims 1-4, wherein calibrating the relevant index data set according to the calibration cycle number comprises:
reducing the sampling cycle ordinal number corresponding to the characterization data in the relevant index data set by the calibration cycle number.

6. The generation method for the chip internal voltage prediction model according to any one of claims 1-5, wherein the sampling cycle is a clock cycle of the chip.

7. A generation apparatus for the chip internal voltage prediction model, comprising:
an obtaining module (110), configured to obtain a load data set and a relevant index data set of a chip respectively, wherein the load data set comprises load data of the chip at each sampling cycle and a sampling cycle ordinal number corresponding to the load data, and the relevant index data set comprises characterization data characterizing a chip internal voltage at the each sampling cycle and a sampling cycle ordinal number corresponding to the characterization data;
a calibration module (120), configured to calibrate the relevant index data set according to a calibration cycle number and obtain a calibrated relevant index data set; and
a training module (130), configured to train the chip internal voltage prediction model based on the load data set and the calibrated relevant index data set and obtain the chip internal voltage prediction model with completed training.

8. A prediction method for a chip internal voltage, comprising:
obtaining (S310) real-time load data of a chip; and
obtaining (S320) prediction data of the chip internal voltage using a chip internal voltage prediction model obtained by the generation method for the chip internal voltage prediction model according to any one of claims 1-6.

9. The prediction method for the chip internal voltage according to claim 8, wherein the real-time load data comprises instruction data and/or cache data, the instruction data is a number of each type of instructions in an instruction life cycle of the chip, and the cache data is a number of reads and writes in progress in a cache of the chip.

10. A prediction apparatus for a chip internal voltage, comprising:
a real-time obtaining module (310), configured to obtain real-time load data of a chip; and
a prediction module (320), configured to obtain prediction data of the chip internal voltage using a chip internal voltage prediction model obtained by the generation method for the chip internal voltage prediction model according to any one of claims 1-6.

11. A storage medium, wherein the storage medium stores a program adapted for generation of a chip internal voltage prediction model so as to implement the generation method for the chip internal voltage prediction model according to any one of claims 1-6, or the storage medium stores a program adapted for prediction of a chip internal voltage so as to implement the prediction method for the chip internal voltage according to claim 8 or 9.

12. An electronic device, comprising at least one memory and at least one processor, wherein the memory stores a program, and the processor invokes the program to perform the generation method for the chip internal voltage prediction model according to any one of claims 1-6, or to perform the prediction method for the chip internal voltage according to claim 8 or 9.

13. A chip, comprising:
an instruction counting unit, configured to obtain a number of each type of instructions in an instruction life cycle of the chip;
a cache access counting unit, configured to obtain a number of reads and writes in progress in a cache of the chip; and
a prediction unit, configured to obtain, using a chip internal voltage prediction model obtained by the generation method for the chip internal voltage prediction model according to any one of claims 1-6, prediction data of a chip internal voltage according to the number of each type of instructions obtained by the instruction counting unit and the number of reads and writes obtained by the cache access counting unit.

## Patentansprüche

1. Erzeugungsverfahren für ein Vorhersagemodell für eine innere Chipspannung, das Folgendes umfasst:
Erhalten (S110) von einem Lastdatensatz bzw. einem relevanten Indexdatensatz eines Chips, wobei der Lastdatensatz Lastdaten des Chips bei jedem Abtastzyklus und eine Abtastzyklusordinalzahl umfasst, die den Lastdaten entspricht, und der relevante Indexdatensatz Charakterisierungsdaten, die eine innere Spannung eines Chips charakterisieren, bei jedem Abtastzyklus und eine Abtastzyklusordinalzahl umfasst, die den Charakterisierungsdaten entspricht;
Kalibrieren (S120) des relevanten Indexdatensatzes gemäß einer Kalibrierungszykluszahl und Erhalten eines kalibrierten relevanten Indexdatensatzes; und
Trainieren (S130) des Vorhersagemodells für die innere Chipspannung auf Basis des Lastdatensatzes und des kalibrierten relevanten Indexdatensatzes und Erhalten des Vorhersagemodells für die innere Chipspannung mit abgeschlossenem Training.

2. Erzeugungsverfahren für das Vorhersagemodell der inneren Chipspannung nach Anspruch 1, wobei die Lastdaten Anweisungsdaten und/oder Cachedaten umfassen, wobei die Anweisungsdaten eine Anzahl von jeder Art von Anweisungen in einem Anweisungslebenszyklus des Chips sind und die Cachedaten eine Anzahl von laufenden Lesevorgängen und Schreibvorgängen in einem Cache des Chips sind.

3. Erzeugungsverfahren für das Vorhersagemodell der inneren Chipspannung nach Anspruch 1 oder 2, wobei die Charakterisierungsdaten Stromüberwachungsdaten und/oder Stromverbrauchsdaten sind.

4. Erzeugungsverfahren für das Vorhersagemodell für die innere Chipspannung nach einem der Ansprüche 1 bis 3, wobei beim Kalibrieren des relevanten Indexdatensatzes gemäß der Kalibrierungszykluszahl und das Erhalten des kalibrierten relevanten Indexdatensatzes ein Berechnungsverfahren für die Kalibrierungszykluszahl Folgendes umfasst:
Aufzeichnen (S121) einer Abtastzyklusordinalzahl T1, die den Lastdaten entspricht, die einen maximalen Wert der Lastdaten erreichen, und einer Abtastzyklusordinalzahl T2, die den Charakterisierungsdaten entspricht, die einen maximalen Wert der Charakterisierungsdaten erreichen, in einem Prozess des allmählichen Erhöhens einer Datenverarbeitungslast des Chips auf einen maximalen Wert und des Haltens eines Zustands des maximalen Werts; und
Übernehmen einer Differenz (S122) zwischen der Abtastzyklusordinalzahl T1, die den Lastdaten entspricht, die den maximalen Wert der Lastdaten erreichen, und der Abtastzyklusordinalzahl T2, die den Charakterisierungsdaten entspricht, die den maximalen Wert der Charakterisierungsdaten erreichen, als die Kalibrierungszykluszahl.

5. Erzeugungsverfahren für das Vorhersagemodell für die innere Chipspannung nach einem der Ansprüche 1 bis 4, wobei das Kalibrieren des relevanten Indexdatensatzes gemäß der Kalibrierungszykluszahl Folgendes umfasst:
Verringern der Abtastzyklusordinalzahl, die den Charakterisierungsdaten im relevanten Indexdatensatz entspricht, um die Kalibrierungszykluszahl.

6. Erzeugungsverfahren für das Vorhersagemodell für die innere Chipspannung nach einem der Ansprüche 1 bis 5, wobei der Abtastzyklus ein Taktzyklus des Chips ist.

7. Erzeugungseinrichtung für das Vorhersagemodell für die innere Chipspannung, das Folgendes umfasst:
ein Erhaltungsmodul (110), das dazu ausgelegt ist, einen Lastdatensatz bzw. einen relevanten Indexdatensatz eines Chips zu erhalten, wobei der Lastdatensatz Lastdaten des Chips bei jedem Abtastzyklus und eine Abtastzyklusordinalzahl umfasst, die den Lastdaten entspricht, und der relevante Indexdatensatz Charakterisierungsdaten, die eine innere Spannung eines Chips charakterisieren, an jedem Abtastzyklus und eine Abtastzyklusordinalzahl umfasst, die den Charakterisierungsdaten entspricht;
ein Kalibriermodul (120), das dazu ausgelegt ist, den relevanten Indexdatensatz gemäß einer Kalibrierungszykluszahl zu kalibrieren und einen kalibrierten relevanten Indexdatensatz zu erhalten; und
ein Trainingsmodul (130), das dazu ausgelegt ist, das Vorhersagemodell für die innere Chipspannung auf Basis des Lastdatensatzes und des kalibrierten relevanten Indexdatensatzes zu trainieren und das Vorhersagemodell für die innere Chipspannung mit abgeschlossenem Training zu erhalten.

8. Vorhersageverfahren für eine innere Chipspannung, das Folgendes umfasst:
Erhalten (S310) von Echtzeitlastdaten eines Chips; und
Erhalten (S320) von Vorhersagedaten der inneren Chipspannung unter Verwendung eines Vorhersagemodells für eine innere Chipspannung, das durch das Erzeugungsverfahren für das Vorhersagemodell für die innere Chipspannung nach einem der Ansprüche 1 bis 6 erhalten wird.

9. Vorhersageverfahren für die innere Chipspannung nach Anspruch 8, wobei die Echtzeitlastdaten Anweisungsdaten und/oder Cachedaten umfassen, wobei die Anweisungsdaten eine Anzahl von jeder Art von Anweisungen in einem Anweisungslebenszyklus des Chips sind und die Cachedaten eine Anzahl von laufenden Lesevorgängen und Schreibvorgängen in einem Cache des Chips sind.

10. Vorhersageeinrichtung für eine innere Chipspannung, die Folgendes umfasst:
ein Echtzeiterhaltungsmodul (310), das dazu ausgelegt ist, Echtzeitlastdaten eines Chips zu erhalten; und
ein Vorhersagemodul (320), das dazu ausgelegt ist, Vorhersagedaten der inneren Chipspannung unter Verwendung eines Vorhersagemodells für eine innere Chipspannung zu erhalten, das durch das Erzeugungsverfahren für das Vorhersagemodell für die innere Chipspannung nach einem der Ansprüche 1 bis 6 erhalten wird.

11. Speichermedium, wobei im Speichermedium ein Programm gespeichert ist, das für eine Erzeugung eines Vorhersagemodells für eine innere Chipspannung angepasst ist, um das Erzeugungsverfahren für das Vorhersagemodell für die innere Chipspannung nach einem der Ansprüche 1 bis 6 zu implementieren, oder im Speichermedium ein Programm gespeichert ist, das für eine Vorhersage einer inneren Chipspannung angepasst ist, um das Vorhersageverfahren für die innere Chipspannung nach Anspruch 8 oder 9 zu implementieren.

12. Elektronische Vorrichtung, die mindestens einen Speicher und mindestens einen Prozessor umfasst,
wobei im Speicher ein Programm gespeichert ist und der Prozessor das Programm aufruft, um das Erzeugungsverfahren für das Vorhersagemodell für die innere Chipspannung nach einem der Ansprüche 1 bis 6 durchzuführen oder das Vorhersageverfahren für die innere Chipspannung nach Anspruch 8 oder 9 durchzuführen.

13. Chip, der Folgendes umfasst:
eine Anweisungszähleinheit, die dazu ausgelegt ist, eine Zahl jeder Art von Anweisungen in einem Anweisungslebenszyklus des Chips zu erhalten;
eine Cachezugriffszähleinheit, die dazu ausgelegt ist, eine Zahl von laufenden Lesevorgängen und Schreibvorgängen in einem Cache des Chips zu erhalten; und
eine Vorhersageeinheit, die dazu ausgelegt ist, unter Verwendung eines Vorhersagemodells für eine innere Chipspannung, das durch das Erzeugungsverfahren für das Vorhersagemodell für die innere Chipspannung nach einem der Ansprüche 1 bis 6 erhalten wird, Vorhersagedaten einer inneren Chipspannung gemäß der Zahl von jeder Art von Anweisungen, die durch eine Anweisungszähleinheit erhalten wird, und die Zahl von Lesevorgängen und Schreibvorgängen, die von der Cachezugriffszähleinheit erhalten wird, zu erhalten.

## Revendications

1. Procédé de génération d'un modèle de prédiction de tension interne d'une puce, comprenant :
l'obtention (S110) d'un ensemble de données de charge et d'un ensemble de données d'indice pertinent d'une puce respectivement, dans lequel l'ensemble de données de charge comprend des données de charge de la puce à chaque cycle d'échantillonnage et un numéro d'ordre de cycle d'échantillonnage correspondant aux données de charge, et l'ensemble de données d'indice pertinent comprend des données de caractérisation caractérisant une tension interne de la puce à chaque cycle d'échantillonnage et un numéro d'ordre de cycle d'échantillonnage correspondant aux données de caractérisation ;
l'étalonnage (S120) de l'ensemble de données d'indices pertinents en fonction d'un numéro de cycle d'étalonnage et l'obtention d'un ensemble de données d'indices pertinents étalonné ; et
entraîner (S130) le modèle de prédiction de la tension interne de la puce sur la base de l'ensemble de données de charge et de l'ensemble de données d'indice pertinent calibré, et obtenir le modèle de prédiction de la tension interne de la puce une fois l'entraînement terminé.

2. Procédé de génération du modèle de prédiction de la tension interne de la puce selon la revendication 1, dans lequel les données de charge comprennent des données d'instructions et/ou des données de cache, les données d'instructions correspondent à un nombre de chaque type d'instructions au cours d'un cycle de vie des instructions de la puce, et les données de cache correspondent à un nombre de lectures et d'écritures en cours dans un cache de la puce.

3. Procédé de génération d'un modèle de prédiction de la tension interne d'une puce selon la revendication 1 ou 2, dans lequel les données de caractérisation sont des données de surveillance de puissance et/ou des données de consommation de puissance.

4. Procédé de génération du modèle de prédiction de tension interne de la puce selon l'une quelconque des revendications 1 à 3, dans lequel, lors de l'étalonnage de l'ensemble de données d'indice pertinent en fonction du nombre de cycles d'étalonnage et de l'obtention de l'ensemble de données d'indice pertinent étalonné, un procédé de calcul du nombre de cycles d'étalonnage comprend :
l'enregistrement (S121) d'un numéro d'ordre de cycle d'échantillonnage T1 correspondant aux données de charge atteignant une valeur maximale des données de charge, et d'un numéro d'ordre de cycle d'échantillonnage T2 correspondant aux données de caractérisation atteignant une valeur maximale des données de caractérisation, dans un processus consistant à augmenter progressivement la charge de calcul de la puce jusqu'à une valeur maximale et à maintenir un état de cette valeur maximale ; et
prendre la différence (S122) entre le numéro ordinal de cycle d'échantillonnage T1 correspondant aux données de charge atteignant la valeur maximale des données de charge et le numéro ordinal de cycle d'échantillonnage T2 correspondant aux données de caractérisation atteignant la valeur maximale des données de caractérisation comme nombre de cycles d'étalonnage.

5. Procédé de génération d'un modèle de prédiction de tension interne de puce selon l'une quelconque des revendications 1 à 4, dans lequel l'étalonnage de l'ensemble de données d'indice pertinent en fonction du numéro de cycle d'étalonnage comprend :
la réduction du numéro d'ordre du cycle d'échantillonnage correspondant aux données de caractérisation dans l'ensemble de données d'indice pertinent du nombre de cycles d'étalonnage.

6. Procédé de génération d'un modèle de prédiction de tension interne de puce selon l'une quelconque des revendications 1 à 5, dans lequel le cycle d'échantillonnage est un cycle d'horloge de la puce.

7. Appareil de génération d'un modèle de prédiction de tension interne d'une puce, comprenant :
un module d'acquisition (110), configuré pour acquérir respectivement un ensemble de données de charge et un ensemble de données d'indice pertinent d'une puce, dans lequel l'ensemble de données de charge comprend des données de charge de la puce à chaque cycle d'échantillonnage et un numéro d'ordre de cycle d'échantillonnage correspondant aux données de charge, et l'ensemble de données d'indice pertinent comprend des données de caractérisation caractérisant une tension interne de la puce à chaque cycle d'échantillonnage et un numéro d'ordre de cycle d'échantillonnage correspondant aux données de caractérisation ;
un module d'étalonnage (120), configuré pour étalonner l'ensemble de données d'indice pertinent en fonction d'un numéro de cycle d'étalonnage et obtenir un ensemble de données d'indice pertinent étalonné ; et
un module d'apprentissage (130), configuré pour entraîner le modèle de prédiction de la tension interne de la puce sur la base de l'ensemble de données de charge et de l'ensemble de données d'indice pertinent calibré, et pour obtenir le modèle de prédiction de la tension interne de la puce une fois l'apprentissage terminé.

8. Procédé de prédiction de tension interne d'une puce, comprenant :
l'obtention (S310) de données de charge en temps réel d'une puce ; et
l'obtention (S320) de données de prédiction de la tension interne de la puce à l'aide d'un modèle de prédiction de la tension interne de la puce obtenu par le procédé de génération d'un modèle de prédiction de la tension interne d'une puce selon l'une quelconque des revendications 1 à 6.

9. Procédé de prédiction de la tension interne d'une puce selon la revendication 8, dans lequel les données de charge en temps réel comprennent des données d'instructions et/ou des données de cache, les données d'instructions correspondent au nombre de chaque type d'instructions dans un cycle de vie d'instructions de la puce, et les données de cache correspondent au nombre de lectures et d'écritures en cours dans un cache de la puce.

10. Appareil de prédiction de la tension interne d'une puce, comprenant :
un module d'obtention en temps réel (310), configuré pour obtenir des données de charge en temps réel d'une puce ; et
un module de prédiction (320), configuré pour obtenir des données de prédiction de la tension interne de la puce à l'aide d'un modèle de prédiction de la tension interne de la puce obtenu par le procédé de génération d'un modèle de prédiction de la tension interne d'une puce selon l'une quelconque des revendications 1 à 6.

11. Support de stockage, dans lequel le support de stockage stocke un programme adapté à la génération d'un modèle de prédiction de tension interne d'une puce de manière à mettre en œuvre le procédé de génération d'un modèle de prédiction de tension interne d'une puce selon l'une quelconque des revendications 1 à 6, ou le support de stockage stocke un programme adapté à la prédiction d'une tension interne de puce de manière à mettre en œuvre le procédé de prédiction de la tension interne d'une puce selon la revendication 8 ou 9.

12. Dispositif électronique, comprenant au moins une mémoire et au moins un processeur,
dans lequel la mémoire stocke un programme, et le processeur invoque le programme pour exécuter le procédé de génération d'un modèle de prédiction de tension interne d'une puce selon l'une quelconque des revendications 1 à 6, ou pour exécuter le procédé de prédiction de la tension interne d'une puce selon la revendication 8 ou 9.

13. Puce, comprenant :
une unité de comptage d'instructions, configurée pour obtenir un nombre de chaque type d'instructions au cours d'un cycle de vie d'instruction de la puce ;
une unité de comptage des accès à un cache, configurée pour déterminer un nombre de lectures et d'écritures en cours dans un cache de la puce ; et
une unité de prédiction, configurée pour obtenir, à l'aide d'un modèle de prédiction de tension interne d'une puce obtenu par le procédé de génération d'un modèle de prédiction de tension interne d'une puce selon l'une quelconque des revendications 1 à 6, des données de prédiction d'une tension interne de la puce en fonction du nombre de chaque type d'instructions obtenu par l'unité de comptage d'instructions et du nombre de lectures et d'écritures obtenu par l'unité de comptage d'accès au cache.
